# EUROPÄISCHE PATENTSCHRIFT

(11) **EP 0 442 289 B1**
(45) Veröffentlichungstag und Bekanntmachung des Hinweises auf die Patenterteilung: **20.04.1994**
(21) Anmeldenummer: 91100727.6
(22) Anmeldetag: 22.01.1991
(51) Int. Cl.: C04B 37/00, C04B 35/00, H01L 39/12, H01L 39/24, H01B 12/00, B23K 1/00

(54) **Verfahren zum Verbinden von Teilen aus keramischem Hochtemperatursupraleitermaterial**
Process for joining parts of ceramic high-temperature superconductive material
Procédé de liaison de parties de matériau céramique supraconducteur à haute température

(30) Priorität: 13.02.1990 DE 4004363
(43) Veröffentlichungstag der Anmeldung: 21.08.1991
(73) Patentinhaber: HOECHST AKTIENGESELLSCHAFT, 65926 Frankfurt am Main (DE)
(72) Erfinder: Preisler, Eberhard, Dr., W-5042 Erftstadt (DE); Bock, Joachim, Dr., W-5042 Erftstadt (DE); Holzem, Johannes, W-5030 Hürth (DE); Horst, Werner, W-5040 Brühl (DE)

(56) Entgegenhaltungen:
- EP-A- 0 347 770
- DE-A- 3 905 424

## Beschreibung

Die vorliegende Erfindung betrifft ein Verfahren zum Verbinden von Teilen aus keramischem Hochtemperatursupraleitermaterial der Zusammensetzung Bi _{(2+a-b)}(Sr_{(1-c)}Ca_{c})₍₃₋ₐ₎Pb_{b}Cu_{(2+d)}Oₓ, wobei a von 0 bis 0,3, b von 0 bis 0,5, c von 0,1 bis 0,9 sowie d von 0 bis 2 betragen und x einen vom Oxidationszustand der enthaltenen Metalle abhängigen Wert hat.

Aus der nicht vorveröffentlichten deutschen Patentanmeldung P 38 30 092.3 ist ein Verfahren zur Herstellung eines Hochtemperatursupraleiters der Zusammensetzung Bi₂(Sr,Ca)₃Cu₂Oₓ mit Werten für x von 8 bis 10 bekannt. Dabei werden stöchiometrische Mischungen der Oxide oder Carbonate von Bismut, Strontium, Calcium und Kupfer auf Temperaturen von 870 bis 1100 °C unter Bildung einer homogenen Schmelze erhitzt. Die homogene Schmelze wird in Kokillen vergossen und erstarrt darin. Die aus den Kokillen entnommenen Gußkörper werden 6 bis 30 Stunden lang bei 780 bis 850 °C getempert und anschließend mindestens 6 Stunden bei 600 bis 830 °C in Sauerstoffatmosphäre behandelt. Auf diese Weise lassen sich Plättchen bis zu mehreren cm Kantenlänge bzw. Durchmesser sowie Stäbe bis zu 50 cm Länge und 10 mm Durchmesser herstellen, welche jeweils aus der phasenreinen Verbindung bestehen.

Von Nachteil ist dabei, daß der oben beschriebene keramische Hochtemperatursupraleiter so spröde ist, daß er zum Transport in Form von langen Stromleitern nicht auf eine Trommel großen Durchmessers (beispielsweise 2 m) aufgerollt werden kann, ohne zu brechen bzw. Rißbildung zu erleiden, insbesondere dann, wenn der Hochtemperatursupraleiter zum Starkstromtransport verwendet werden soll.

Es sind auch bereits keramische Hochtemperatursupraleiter in Pulverform in Silberrohre eingefüllt und die Rohre durch Rundhämmern und Tiefziehen elongiert worden, bis "Drähte" des gewünschten Durchmessers vorlagen, wobei das im Innenraum der Silberrohre befindliche Hochtemperatursupraleiter-Pulver durch Temperung zu einer zusammenhängenden Seele sinterbar ist. Der für die Bildung des Supraleiters erforderliche Sauerstoff diffundiert dabei durch die Wandung der Silberrohre hindurch.

Die genannten "Pulver in Rohr"-Leiter halten einen bestimmten Grad an Verbiegung aus, so daß sie prinzipiell als Transportstromleiter einsetzbar sind. Nachteilig ist jedoch bei ihnen, daß sie nur bei kleinem Durchmesser ohne Zerstörung verbiegbar sind und nicht zu komplizierteren Systemen zusammengeschaltet werden können.

Es ist daher Aufgabe der vorliegenden Erfindung, ein Verfahren zum Verbinden von Teilen aus keramischem Hochtemperatursupraleitermaterial zu komplizierteren und ausgedehnteren Strukturen anzugeben, bei welchen auch die Verbindungsstellen supraleitend sind. Das wird erfindungsgemäß dadurch erreicht, daß man die Stirnflächen der in spaltförmigem Abstand voneinander befindlichen Teile mit Hilfe einer Brenngas-Sauerstoff-Flamme auf Temperaturen von 750 bis 875 °C erhitzt und gleichzeitig einen Stab aus gleichem Material oberhalb des spaltförmigen Abstandes soweit erhitzt, daß dessen Schmelze zwischen den Stirnflächen beider Teile in den Spalt unter vollständiger Ausfüllung des Spaltes abtropft, und daß man anschließend mindestens den Verbindungsbereich zwischen beiden Teilen 7 bis 100 Stunden bei Temperaturen zwischen 780 und 850 °C tempert.

Das Verfahren gemäß der Erfindung kann weiterhin wahlweise auch noch dadurch ausgestaltet sein, daß
a) man bei Temperaturen von 815 bis 830 °C tempert,
b) die Temperungszeit von der Dicke der Verbindungsstelle abhängt, wobei eine dickere Verbindungsstelle eine längere Temperungszeit erfordert und umgekehrt,
c) die Stirnflächen der zu verbindenden Teile parallel zueinander angeordnet sind,
d) die Stirnflächen der zu verbindenden Teile keilförmig zueinander angeordnet sind,
e) die zu verbindenden Teile aus dem keramischen Hochtemperaturleitermaterial jeweils von einem Silberrohr ummantelt sind.

Die erfindungsgemäß verwendeten Verbindungen, beispielsweise Bi₂(Sr,Ca)₃Cu₂Oₓ (mit x von etwa 8,2) schmelzen inkongruent, d.h., sie weisen keinen Schmelzpunkt, sondern ein Schmelzintervall auf. Weiterhin ist die Oberflächenspannung dieser Schmelze gegenüber der festen Phase an Luft so groß, daß die Schmelze nicht sofort von der festen Phase abläuft. Beide Eigenschaften sind gute Voraussetzungen für ein Verhalten, welches dem beim Verbinden von Metallen durch Autogenschweißung ähnlich ist.

Das Aufschmelzen der gemäß der Verbindung Bi₂(Sr,Ca)₃Cu₂Oₓ (mit x von etwa 8,2) beispielsweise erfolgt oberhalb von 875 °C unter Sauerstoffverlust, wobei sich die Schmelztemperatur bei x von etwa 7,5 auf ca. 780 °C vermindert. Der nach dem Erstarren dieser Schmelze vorliegende Festkörper ist nicht mehr supraleitend, er kann jedoch durch Tempern bei etwa 800 °C an Luft wieder in den supraleitenden Zustand überführt werden.

Beim erfindungsgemäßen Verfahren ist darauf zu achten, daß die Stirnflächen der zusammenzufügenden Teile so heiß sind, daß sie sich mit der vom erhitzten Stab abtropfenden Schmelze verbinden können.

Beim Verfahren gemäß der Erfindung tempert man eine dünne Verbindungsstelle 8 bis 15 Stunden, während eine dickere Verbindungsstelle bis zu 100 Stunden getempert wird.

Die Temperung der Verbindungsstelle zwischen den Teilen kann dadurch erfolgen, daß man das gesamte neu geschaffene Formteil in einem Ofen der Wärmebehandlung unterzieht. Die Temperung kann aber auch lokal erfolgen, indem um die Verbindungsstelle ein elektrischer Miniaturofen mit genauer Temperaturmessung und -regelung angeordnet wird, oder durch lokale Hochfrequenzinduktionsheizung oder durch direkte Heizung mit quer zur Verbindungsstelle angeordneten Elektroden oder durch Laserimpulse.

Bei der erfindungsgemäßen Verschweißung von mit Silberrohr ummantelten Formkörpern aus hochtemperatursupraleitendem Keramikmaterial muß besonders darauf geachtet werden, daß die Brenngas-Sauerstoff-Flamme nicht mit dem Silbermantel in Berührung kommt und diesen aufschmilzt, denn die Schmelzpunkte des Silbers und der hochtemperatursupraleitenden Verbindung liegen nicht weit auseinander. Der silberfreie Verbindungsbereich zwischen den beiden erfindungsgemäß verbundenen Teilen kann nachträglich gegebenenfalls mit Silber ummantelt werden.

In der beigefügten Zeichnung sind Anwendungen des erfindungsgemäßen Verfahrens schematisch und im Querschnitt dargestellt. Dabei zeigen:
- Fig. 1: Verbindung zweier Rundstäbe bei parallel zueinander angeordneten Stirnflächen,
- Fig. 2: Verbindung zweier dickerer Rundstäbe bei keilförmig zueinander angeordneten Stirnflächen,
- Fig. 3: Verbindung eines dickeren und eines dünneren Rundstabes bei parallel zueinander angeordneten Stirnflächen,
- Fig. 4: Verbindung einer dünnen Scheibe mit einem Rundstab bei parallel zueinander angeordneten Stirnflächen,
- Fig. 5: Vorrichtung zur lokalen Temperung von Verbindungen von Rundstäben,
- Fig. 6: Temperatur-Widerstands-Diagramme.

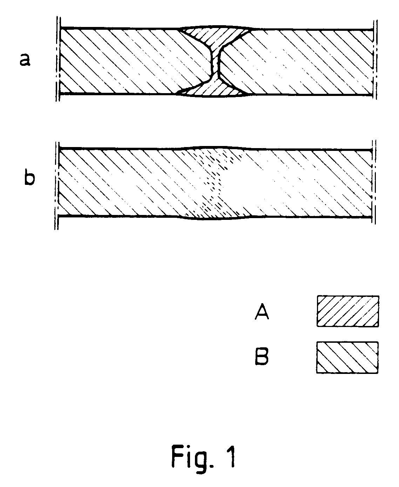

In Fig. 1 geben die Schraffur A die erstarrte, nicht supraleitende Schmelze und die Schraffur B die nachgetemperte, supraleitende Verbindung wieder.
Bild a zeigt die Verbindung der Rundstäbe unmittelbar nach dem Erstarren der in den Spalt eingetropften Schmelze, während Bild b die Verbindungsstelle nach 24stündiger Temperung bei 815 °C zeigt.

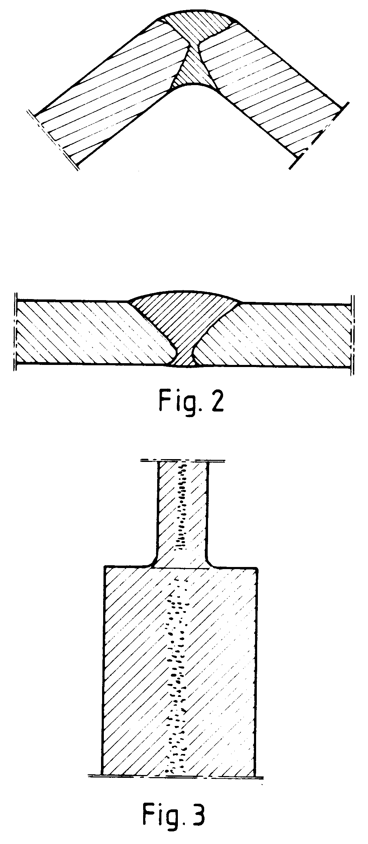

In Fig. 3 befinden sich in der Längsachse des dickeren und dünneren Rundstabes Lunkerbereiche.

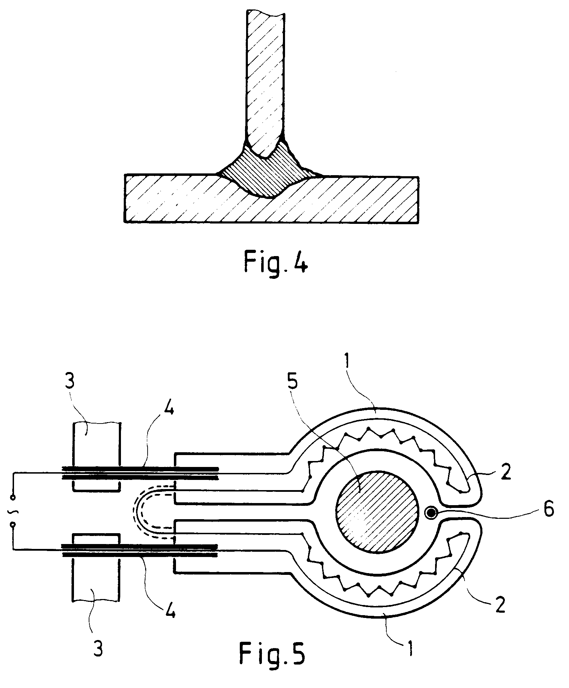

In Fig. 5 ist ein keramischer Heizungsträger 1, in welchem sich Widerstandsheizspiralen 2 befinden, über Rohrdurchführungen 4 in Halterungen 3 befestigt. 5 gibt die Verbindungsnaht zweier Rundstäbe aus keramischem Hochtemperatursupraleitermaterial wieder. Nahe der Verbindungsnaht 5 ist ein Thermoelement 6 angeordnet.

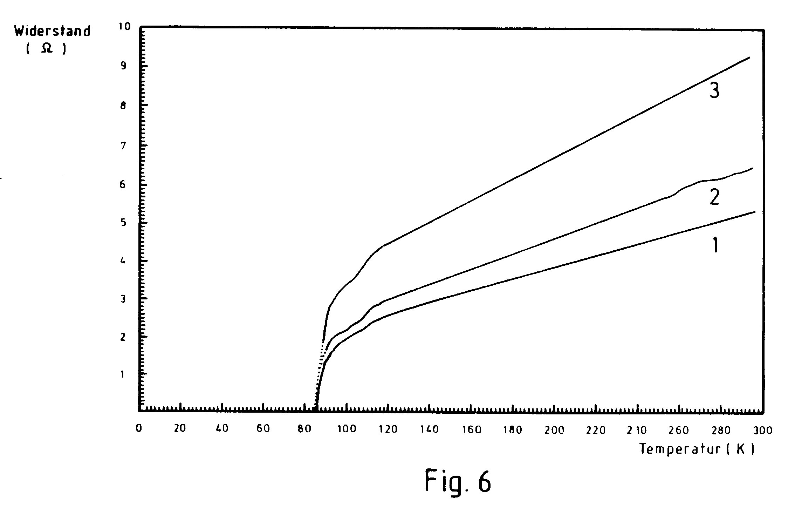

In Fig. 6 sind drei Messungen an den gemäß Beispiel 1 erfindungsgemäß verbundenen Teilen wiedergegeben; und zwar zeigen die Kurven 1 und 2 die Messungen an jedem der verbundenen Teile und Kurve 3 die Messung im Verbindungsbereich beider Teile über die Schweißstelle hinweg.

### Beispiel 1

Zwei nach dem Verfahren gemäß der deutschen Patentanmeldung P 38 30 092.3 hergestellte Rundstäbe von 5 mm Durchmesser und 150 mm Länge wurden auf einer keramischen Unterlage bis auf einen Spalt so zusammengeschoben, daß ihre Stirnflächen parallel zueinander verliefen. Die Stirnflächen wurden mit Hilfe einer Erdgas-Sauerstoff-Flamme auf helle Rotglut erhitzt. Gleichzeitig wurde oberhalb des Spaltes ein Rundstab aus gleichem Material so stark erhitzt, daß Schmelze in den Spalt abtropfte. Durch langsames Drehen beider Rundstäbe wurde der Spalt gleichmäßig mit Schmelze ausgefüllt (vergl. Figur 1, Bild a). Nach 12stündiger Temperung der verbundenen Rundstäbe bei 815 °C in einem Ofen war die Verbindungszone zwischen beiden Rundstäben supraleitend (vergl. Figur 1, Bild b).
Die Sprungtemperatur der Verbindungszone beider Rundstäbe betrug 85,5 K; links und rechts davon wurden Sprungtemperaturen von 86,0 bzw. 86,5 K gemessen (vergl. Fig. 6).

### Beispiel 2

Zwei nach dem Verfahren gemäß der deutschen Patentanmeldung P 38 30 092.3 hergestellte Rundstäbe von 12 mm Durchmesser und 300 mm Länge wurden mit ihren Stirnflächen keilförmig zueinander angeordnet. Mit Hilfe einer Propangas-Sauerstoff-Flamme wurde der offene Keil von der Basis her erhitzt und angeschmolzen, bevor Schmelze von einem abtropfenden Rundstab aus gleichem Material von oben her in den Keil tropfte und ihn vollständig ausfüllte (vergl. Fig. 2). Anschließend wurden die verbundenen Rundstäbe in einem Ofen 24 Stunden bei 800 °C getempert.
Zur Kontrolle, ob die Verbindungszone zwischen den beiden Rundstäben nunmehr supraleitend war, wurde der spezifische Widerstand der verbundenen Rundstäbe gemessen.
Bei 293 K vor Temperung: 1 Ω .cm
Bei 293 K nach Temperung: 0,001 Ω .cm
Bei 77 K nach Temperung: 0 Ω .cm

### Beispiel 3

Beispiel 2 wurde mit der Änderung wiederholt, daß ein Rundstab von 5 mm Durchmesser und 120 mm Länge und ein Rundstab von 16 mm Durchmesser und 40 mm Länge so in eine Halterungseinrichtung eingeklemmt wurden, daß ihre Achsen zentriert und ihre Stirnflächen parallel zueinander angeordnet waren (vergl. Fig. 3).
Die Messung des spezifischen Widerstandes der verbundenen Rundstäbe ergab:
Bei 293 K vor Temperung: 2,8 Ω .cm
Bei 293 K nach Temperung: 0,0015 Ω .cm
Bei 77 K nach Temperung: 0 Ω .cm

### Beispiel 4

Beispiel 2 wurde mit der Änderung wiederholt, daß ein Rundstab von 5 mm Durchmesser und 80 mm Länge senkrecht mit einer kreisförmigen Platte (20 mm Durchmesser, 5 mm Dicke) verbunden wurde (vergl. Fig. 4). Dabei wurde darauf geachtet, daß die Erhitzung der dünnen Scheibe weniger intensiv als die des Rundstabes war.

### Beispiel 5

Beispiel 2 wurde mit den Änderungen wiederholt, daß Rundstäbe von 8 mm Durchmesser miteinander verbunden wurden und die Temperung durch lokale Wärmebehandlung der Verbindungszone erfolgte. Es wurde dazu ein elektrischer Miniaturofen benutzt, welcher im Bereich der Verbindungszone um den Rundstab gelegt und mit einer Wärmeisolierung aus Aluminiumoxidwolle versehen wurde. Zur Temperaturkontrolle diente ein seitlich eingeführtes Thermoelement (vergl. Fig. 5).

## Patentansprüche

1. Verfahren zum Verbinden von Teilen aus keramischem Hochtemperatursupraleitermaterial der Zusammensetzung Bi_{(2+a-b)}(Sr_{(1-c)}Ca_{c})₍₃₋ₐ₎Pb_{b}Cu_{(2+d)}Oₓ, wobei a von 0 bis 0,3, b von 0 bis 0,5, c von 0,1 bis 0,9 sowie d von 0 bis 2 betragen und x einen vom Oxidationszustand der enthaltenen Metalle abhängigen Wert hat, dadurch gekennzeichnet, daß man die Stirnflächen der in spaltförmigem Abstand voneinander befindlichen Teile mit Hilfe einer Brenngas-Sauerstoff-Flamme auf Temperaturen von 750 bis 875°C erhitzt und gleichzeitig einen Stab aus gleichem Material oberhalb des spaltförmigen Abstandes soweit erhitzt, daß dessen Schmelze zwischen den Stirnflächen beider Teile in den Spalt unter vollständiger Ausfüllung des Spaltes abtropft, und daß man anschließend mindestens den Verbindungsbereich zwischen beiden Teilen 7 bis 100 Stunden bei Temperaturen zwischen 780 und 850°C tempert.

2. Verfahren nach Anspruch 1, dadurch gekennzeichnet, daß man bei Temperaturen von 815 bis 830°C tempert.

3. Verfahren nach Anspruch 1 oder 2, dadurch gekennzeichnet, daß die Temperungszeit von der Dicke der Verbindungsstelle abhängt, wobei eine dickere Verbindungsstelle eine längere Temperungszeit erfordert und umgekehrt.

4. Verfahren nach mindestens einem der Ansprüche 1 bis 3, dadurch gekennzeichnet, daß die Stirnflächen der zu verbindenden Teile parallel zueinander angeordnet sind.

5. Verfahren nach mindestens einem der Ansprüche 1 bis 3, dadurch gekennzeichnet, daß die Stirnflächen der zu verbindenden Teile keilförmig zueinander angeordnet sind.

6. Verfahren nach mindestens einem der Ansprüche 1 bis 5, dadurch gekennzeichnet, daß die zu verbindenden Teile aus dem keramischen Hochtemperaturleitermaterial jeweils von einem Silberrohr ummantelt sind.

## Claims

1. A method for joining parts of ceramic high-temperature superconductor material of the composition Bi_{(2+a-b)} (Sr_{(1-c)}Ca_{c}) ₍₃₋ₐ₎Pb_{b}Cu_{(2+d)}Oₓ, where a is 0 to 0.3, b is 0 to 0.5, c is 0.1 to 0.9, d is 0 to 2 and x has a value depending on the state of oxidation of the metals present, which comprises heating the end faces of the parts located at a gap spacing apart from one another by means of a fuel gas/oxygen flame to temperatures from 750 to 875°C and simultaneously heating a rod of the same material above the spacing gap until the melt thereof drips off into the gap between the end faces of the two parts, completely filling the gap, and then heat-treating at least the joint region between the two parts for 7 to 100 hours at temperatures between 780 and 850°C.

2. The method as claimed in claim 1, wherein the heat treatment is carried out at temperatures from 815 to 830°C.

3. The method as claimed in claim 1 or 2, wherein the heat treatment time depends on the thickness of the junction, a thicker junction requiring a longer heat treatment time and vice versa.

4. The method as claimed in at least one of claims 1 to 3, wherein the end faces of the parts to be joined are in a mutually parallel arrangement.

5. The method as claimed in at least one of claims 1 to 3, wherein the end faces of the parts to be joined are in a wedge-shaped mutual arrangement.

6. The method as claimed in at least one of claims 1 to 5, wherein the ceramic high-temperature conductor material parts to be joined are each sheathed by a silver tube.

## Revendications

1. Procédé d'assemblage de pièces en matériau céramique supraconducteur haute température de composition Bi(_{2+a-b})(Sr_{(1-c)}Ca_{c})₍₃₋ₐ₎ Pb_{b}Cu_{(2+d)}Oₓ, a étant compris entre 0 et 0,3, b entre 0 et 0,5, c entre 0,1 et 0,9 et d entre 0 et 2 et x ayant une valeur dépendant de l'état d'oxydation des métaux contenus, caractérisé en ce qu'on chauffe les faces frontales des pièces séparées par un intervalle en forme de fente à l'aide d'une flamme de gaz combustible-oxygène à des températures comprises entre 750 et 875°C, tout en chauffant une baguette du même matériau au-dessus de l'intervalle en forme de fente jusqu'à ce que sa masse fondue goutte entre les faces frontales des deux pièces dans la fente en la comblant totalement, et qu'on recuit ensuite au moins la zone d'assemblage entre les deux pièces pendant 7 à 100 h à des températures comprises entre 780 et 850°C.

2. Procédé selon la revendication 1, caractérisé en ce qu'on recuit à des températures comprises entre 815 et 830°C.

3. Procédé selon la revendication 1 ou 2, caractérisé en ce que la durée du recuit est proportionnelle à l'épaisseur du site d'assemblage, un site d'assemblage relativement épais nécessitant un recuit plus long et vice versa.

4. Procédé selon au moins une des revendications 1 à 3, caractérisé en ce que les faces frontales des pièces à assembler sont parallèles.

5. Procédé selon au moins une des revendications 1 à 3, caractérisé en ce que les faces frontales des pièces à assembler sont disposées en forme de coin.

6. Procédé selon au moins une des revendications 1 à 5, caratérisé en ce que les pièces à assembler en matériau céramique supraconducteur haute température sont gainées chacune d'un tube en argent.
